# EUROPEAN PATENT SPECIFICATION

(11) **EP 1 930 963 B1**
(45) Date of publication and mention of the grant of the patent: **02.03.2016**
(21) Application number: 06125574.1
(22) Date of filing: 07.12.2006
(51) Int. Cl.: H01L 51/40, H01L 51/10

(54) **Method of manufacturing a semiconducting device and semiconducting device**
Methode zum Herstellen einer halbleitenden Vorrichtung und halbleitende Vorrichtung
Méthode de fabrication d'un dispositif semi-conducteur et dispositif semi-conducteur

(43) Date of publication of application: 11.06.2008
(73) Proprietor: Samsung Display Co., Ltd., Gyeonggi-do (KR)
(72) Inventor: Fischer, Joerg, 13053, Berlin (DE); Mathea, Arthur, 14197, Berlin (DE); Schaedig, Marcus, 15711, Königs Wusterhausen (DE)
(74) Representative: Gulde & Partner

(56) References cited:
- EP-A1- 1 657 751
- WO-A-01/17041
- WO-A-01/47044
- GB-A- 2 418 062
- US-A1- 2002 022 299
- US-A1- 2006 024 859
- US-A1- 2006 131 573
- KAWASE T ET AL: "INKJET PRINTED VIA-HOLE INTERCONNECTIONS AND RESISTORS FOR ALL-POLYMER TRANSISTOR CIRCUITS" ADVANCED MATERIALS, WILEY VCH, WEINHEIM, DE, vol. 13, no. 21, 2 November 2001 (2001-11-02), pages 1601-1605, XP001129628 ISSN: 0935-9648

## Description

### FIELD OF THE INVENTION

This invention relates to a semiconducting element (semiconducting device) comprising a substrate having a patterned structure of organic semiconducting material and a method for manufacturing the semiconducting element, as e.g. disclosed in US 2006/0024859 A1; GB 2 418 062 A; WO 01/47044; T. Kawase et al., Advanced Materials, vol. 13, no. 21 (2001), pages 1601-1605; US 2006/0 131 573 A1; US 2002/0 022 299 A1 and EP 1 657 751 A1. More particularly, the present invention relates to a substrate comprising a plurality of organic thin film transistors and a method for manufacturing the plurality of organic thin film transistors on the substrate.

### BACKGROUND OF THE INVENTION

At least one thin film transistor (TFT) is required in active matrix organic light emitting displays for each pixel. In order to reduce manufacturing costs organic thin film transistors are preferably used. The plurality of organic thin film transistors (OTFT) is usually arranged in a matrix wherein the organic semiconducting material (OSC) has to be patterned. As disclosed in GERWIN H. GELINCK et. al "Flexible active-matrix displays and shift registers based on solution-processed organic transistors", Nature Materials 3, 106-110 (2004), the patterning of organic semiconducting material is essential to achieve a good single transistor performance such as high ON/OFF current ratio. The patterning is also required to prevent unwanted cross talk effect between neighbour TFTs and conductive lines in an electronic circuit. The non patterned semiconductor material can cause a current leakage path. Direct patterning technologies such as additive printing: I/J printing, flexo printing or others can be used to pattern the organic semiconducting material. However, this often causes non uniform OSC layer profile due to the printing process, e.g. due to drying of the ink. Therefore a large OTFT to OTFT variation can be obtained which reduces the uniformity of the brightness of the display. Another alternative way is to use photolithography incl. etching processes. But these processes are complicated, expensive and can harm the OSC material.

### OBJECTS OF THE INVENTION

Therefore one object of the invention is to provide a method for manufacturing a semiconducting element comprising a substrate having a patterned structure of organic semiconducting material which is cost-effective and which realizes a structure having a high degree of uniformity of the patterned semiconducting regions. Another object of the invention is to avoid cross-talk between adjacent patterned semiconducting regions.

### SUMMARY OF THE INVENTION

The object is achieved for the method by the features of claim 1 and for the semiconducting device by the features of claim 9. Embodiments described in the following, in which the OSC layer is completely removed are not part of the claimed invention, but are useful for the understanding of the invention as claimed.

This invention uses a new approach to combine the benefits of large area solution coating processes for applying a continuous organic semiconducting layer and ink jet printing of a solvent for patterning the organic semiconducting layer. This advantageously results in an uniform OSC layer thickness and a low OTFT-to-OTFT variation. Furthermore only two cheap steps for the OSC patterning process are required. Various solution deposition methods can be used for applying a continuous organic semiconducting layer (to deposit the OSC material), which results in uniform film forming: Spin coating, blade coating, dip casting and the like. Once the continuous organic semiconducting layer is formed a second step is used to pattern the continuous organic semiconducting layer. Ink jet printing can be used to print solvents and dissolve the OSC layer around the single OTFTs (which one of a plurality of OTFTs). The patterning can for example form a "ring" of non OSC area (completely removing the OSC material by patterning is not part of the invention as claimed) around the OTFTs and can therefore prevent a current leakage path and unwanted cross talk effects. The invention can be used for both bottom gate and top gate OTFTs.

According to a first aspect, which is not part of the invention as claimed, but which is useful for the understanding of the invention, a method for manufacturing a semiconducting element comprising a substrate (preferably a glass or plastic substrate) having a patterned structure of organic semiconducting material is disclosed, wherein the patterned structure comprises a plurality of first regions, wherein each first region comprises organic semiconducting material having a thickness being equal or higher than a first thickness, and a plurality of second regions, wherein each second region comprises no organic semiconducting material. According to the invention, each second region comprises organic semiconducting material having a thickness being equal or lower than a second thickness. The method comprises:
providing a substrate; applying a continuous layer of an organic semiconducting material onto the substrate; applying a solvent onto the continuous layer in the second regions thereby dissolving and removing organic semiconducting material, which is located in the second regions, from the continuous layer. The plurality of first regions is preferably not inter-connected with each other. The plurality of second regions can be either be inter-connected with each other or be separated from each other. According to the invention "a plurality" of OTFTs means at least two OTFT, preferably more than 100 OTFTs. The same (analogous) meaning applies to "a plurality" of first regions etc.

Then semiconducting material can be completely removed by applying a little solvent locally (this embodiment is not part of the claimed invention). During drying the semiconducting material of the dissolved area retracts towards the remaining solid semiconducting material, resulting in a region without semiconducting material, which is not part of the invention as claimed.

The semiconducting material is completely removed by the application of the solvent, which is not part of the invention as claimed. According to the invention as claimed, the organic semiconducting material is removed (by the application of the solvent) such that the minimum thickness of the organic semiconducting material in the first regions is at least five times higher (preferably at least eight times higher and still more preferably at least ten times higher) than the thickness of the organic semiconducting material in the second regions.

Preferably the application of the solvent onto the second regions is carried out by ink jet printing of the solvent onto the second regions. Preferably at least one of poly-3-alkylthiophene, poly-co-(dioctylfluorenyl-dithiophen-yl), poly-alkyltriarylamine, dihexylsexithiophene, starshaped oligothiophenes, poly(alkylterthiophene), poly(alkylquarterthiophene), functionalized acenes, functionalized pentacenes and bis-(tri-ethylsilylethinyl)-anthradithiophene) is used for the organic semiconducting material.

Preferably a solvent having a boiling point between 100°C and 180°C is used. Preferably at least one of Bis-(Tri-isopropylsilylethinyl)-Pentacene, regioregular Poly-3-hexylthiophene and regioregular Poly-3-decylthiophene is used for the organic semiconducting material and/or one of N-acetyl-6,13-epithioimino-6,13-dihydropentacene-S-oxide and 6,13-epitetrachlorbenzo-6,13-dihydropentacene is used as a pentacene pre-cursor. Preferably at least one of chloroform, tetra hydro furan (THF), xylene, hexane, toluene, cyclohexane, anisole, 3,4dimethylanisole, 1,2dichlorobenzene, tetralin, 1,2,4trimethylbenzene, 1,2,3trimethlbenzene, 1,3,5trimethlbenzene, methyl benzoate, ethyl benzoate is used for the solvent.

According to a first preferred embodiment a plurality of pairs of source electrodes and drain electrodes are applied onto the substrate prior to the step of applying a continuous layer of an organic semiconducting material. Preferably the method furthermore comprises: forming an insulating layer on the patterned structure and forming a plurality of gate electrodes on the insulating layer in areas between source electrodes and drain electrodes of the same pair.

According to a second preferred embodiment a plurality of gate electrodes are formed on the substrate and an insulating layer is formed on the plurality of gate electrodes and a plurality of pairs of source electrodes and drain electrodes are formed on the insulating layer prior to the step of applying a continuous layer of an organic semiconducting material.

In both of the above-mentioned preferred embodiments at least one second region is formed between adjacent pairs of source and drain electrodes wherein no second region is formed between source electrodes and drain electrodes of the same pair. Preferably two second regions are formed between adjacent pairs of source and drain electrodes. The plurality of transistors (one transistor is formed by one pairs of source, drain and gate wherein a channel of organic semiconducting material is disposed between source and drain and an insulating layer is arranged between the gate and the channel) are preferably spaced apart by a uniform distance from each other and are preferably arranged in a matrix shape on the substrate.

The solvent is preferably applied to cover an annular area thereby forming a second region or second regions (comprising no organic semiconducting material due to the fact that the solvent dissolves and removes the organic semiconducting material in the second region and according to the aspect that is not part of the claimed invention) comprising an annular shape. Preferably the solvent is applied such each OTFT is fully surrounded by a second region. The second regions can be separated from an adjacent second region or can be inter-connected with each other. The first regions preferably comprise a circular shape. Preferably each transistor is fully covered by one first region which is not inter-connected with a first region covering an adjacent OTFT.

In an alternative preferred embodiment, the solvent is preferably applied in lines which extend along an vertical or horizontal axis of the matrix (or the edges of the substrate) and the lines are preferably located between adjacent rows or columns of transistors. Furthermore the solvent is preferably applied in both vertical and horizontal lines of the matrix. Therefore, the second regions preferably comprise a line shape or stripe shape wherein the first regions preferably comprise a square shape covering the OTFT channels. The continuous layer of organic semiconducting material is preferably applied with a layer thickness between 10 and 200 nm, more preferably between 20 and 100 nm. Furthermore the line width of the printed solvent respectively the width of the second regions is preferably between 10 and 200 µm, more preferably between 20 and 100 µm.

Preferred combination of organic semiconducting material and solvent is Bis-(Tri-isopropylsilylethinyl)-Pentacene 1%-10% (preferably 2%-6%, more preferably 4%) solution in tetralin for deposition of the continuous semiconductor layer by e.g. spin coating and xylene for patterning of the same by solvent drop method.

According to a second aspect of the invention a semiconducting element comprising a substrate (preferably a planar glass or plastic substrate) having a patterned structure of organic semiconducting material is disclosed, the patterned structure comprising a plurality of first regions, wherein each first region comprises organic semiconducting material having a thickness being equal or higher than a first thickness, and a plurality of second regions, wherein each second region comprises no organic semiconducting material (according to the aspect that is not covered by the claimed invention) or wherein each second region comprises organic semiconducting material having a thickness being equal or lower than a second thickness (according to the aspect that is covered by the claimed invention), wherein at least one second region (preferably a plurality of second regions) comprises traces of a solvent and/or wherein the edge areas of the first regions comprise a higher thickness than the central areas of the first regions, i.e. at least one edge area of at least one first region comprises a higher thickness than at the central area of the at least one first region, and preferably the edge areas of all first regions comprise a higher thickness than the central areas of all first regions.

It is also possible that the second regions comprise no organic semiconducting material, which is not covered by the claimed invention. According to the invention, the minimum thickness of the organic semiconducting material in the first regions is at least five times higher ( preferably at least eight times higher and more preferably at least ten times higher) than the maximum thickness of the organic semiconducting material in the second regions.

The thickness of an edge area of at least one first region is higher (at least 10% higher) than the thickness of the central area of the at least one first region. More preferably the thickness of the edge area of the first regions is between 30% and 300% (and still more preferably between 50% and 150%) higher than the thickness of the central area of the first regions.

The semiconducting element comprises a plurality of TFTs. For a top gate OTFT a plurality of pairs of source electrodes and drain electrodes are arranged between the substrate and the organic semiconducting material (first regions) and an insulating layer is arranged on the patterned structure (of first and second regions) and a plurality of gate electrodes is arranged on the insulating layer in areas between source electrodes and drain electrodes of the same pair.

For a bottom gate OTFT a plurality of gate electrodes are formed between the substrate and an insulating layer, whereby a plurality of pairs of source electrodes and drain electrodes are formed on the insulating layer and at least one second region is formed between adjacent pairs of source and drain electrodes wherein no second region is formed between source electrodes and drain electrodes of the same pair.

Preferably the semiconducting element having a plurality of OTFTs is used for an OLED device. Therefore, preferably the plurality of OTFTs are connected to organic light emitting diode (as switching or driving transistors) and the diodes are furthermore coupled to respective electrodes.

### BRIEF DESCRIPTION OF THE DRAWINGS

The present invention will now be described by way of example with reference to the accompanying drawings, in which:
- Fig. 1a: shows a cross sectional view of a bottom gate organic thin film transistor,
- Fig. 1b: shows a cross sectional view of a top gate organic thin film transistor,
- Fig. 2: illustrates the method according to the present invention showing a cross sectional view of a section of a plurality of bottom gate OTFTs comprising a solution deposited continuous organic semiconducting layer,
- Fig. 3: illustrates the method according to the present invention showing a cross sectional view of a section of a plurality of a bottom gate OTFTs comprising an OSC patterning step by printing a solvent in order to dissolve the OSC layer around each OTFT,
- Fig. 4: shows a top view of a section of a plurality of a bottom gate OTFTs comprising a patterned OSC layer manufactured by printing a solvent in order to dissolve the OSC layer around each OTFT,
- Fig. 5: shows a cross sectional view of a section of a plurality of a top gate OTFTs comprising a patterned OSC layer manufactured by printing a solvent in order to dissolve the OSC layer around each OTFT, and
- Fig. 6: shows a top view of a section of a plurality of a top gate OTFTs comprising a patterned OSC layer manufactured by printing a solvent in order to dissolve the OSC layer around each OTFT, and
- Fig. 7-10: a top view of the steps of manufacturing a display comprising a plurality of pixels, each pixel comprising an OTFT according to the invention,
- Fig. 11: a sectional view of an semiconducting element comprising an agglomeration of semiconducting material in the edge portions of the first regions resulting from the manufacturing method, wherein the second regions are completely removed by the application of the solvent, and
- Fig. 12: a sectional view of an semiconducting element comprising an agglomeration of semiconducting material in the edge portions of the first regions resulting from the manufacturing method, wherein the second regions are partially removed by the application of the solvent.

### DETAILED DESCRIPTION OF PREFERRED EMBODIMENTS

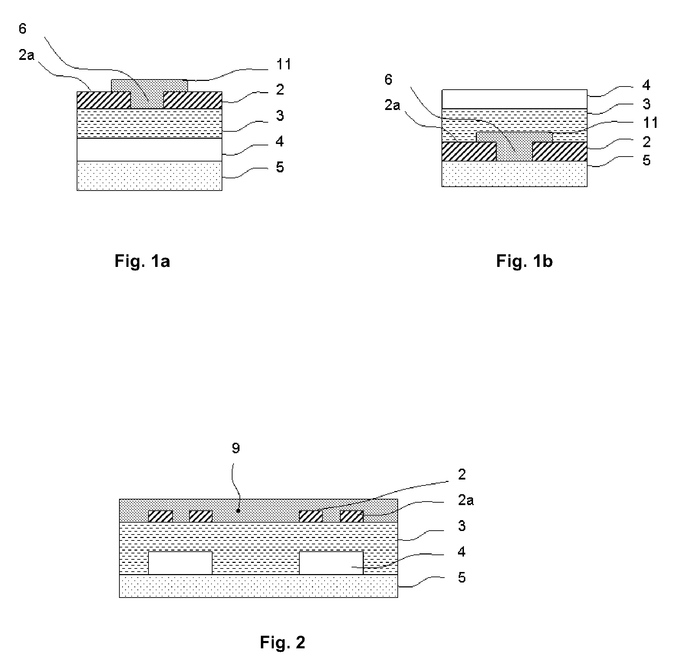

Figures 1 a to 11 are useful for the understanding of the invention as claimed, but do not concern exemplary embodiments of the claimed invention.

Fig. 1 a and 1 b show cross sectional views of a bottom gate (Fig. 1 a) and a top gate (Fig. 1 b) organic thin film transistor comprising a substrate 5, gate 4, insulating layer 3, source 2, drain 2a and a channel 6 of organic semiconducting material (OSC). For a plurality of applications, e.g. display applications a substrate comprising a plurality of OTFTs (bottom gate or top gate OTFTs) are required wherein the OTFTs functions as driving transistors or switching transistors in an active matrix display. For example an organic active matrix light emitting display comprises a substrate, the substrate comprising a plurality of pixels, each pixel comprising at least one OTFT and at least one organic light emitting element (OLED), and each pixel being connected to at least one of a plurality of scan lines and to at least one of a plurality of data lines. For a high degree of uniformity of brightness the electric characteristics of the plurality of OTFTs has to be very uniform. Furthermore cross-talk between adjacent OTFTs has to be avoided.

Fig. 2 illustrates the method according to the present invention showing a cross sectional view of a section of a plurality of bottom gate OTFTs comprising a solution deposited continuous organic semiconducting layer. According to the invention a plurality of OTFTs can be cost-effectively manufactured (either bottom gate or top gate OTFTs) reducing cross-talk between adjacent OTFTs and increasing uniformity of the electric characteristics of the plurality of OTFTs.

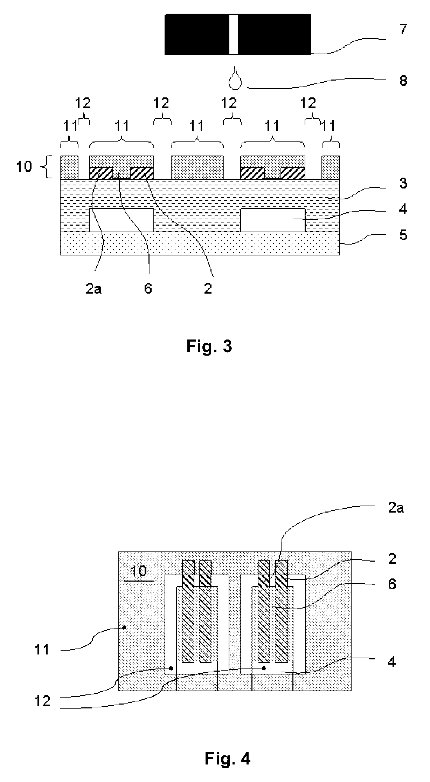

Therefore a plurality of pairs of source and drain electrodes 2, 2a (or source and drain contacts 2, 2a) are applied on the substrate 5 and a continuous layer 9 of organic semiconducting material is applied to cover the substrate 5 and the plurality of source and drain electrodes 2, 2a. In case of bottom gate OTFTs (as shown in Fig. 2) for each of the OTFTs a gate electrode 4 is applied prior to the application of the source and drain electrodes 2, 2a and furthermore a continuous insulating layer 3 is applied to cover the plurality of gate electrodes 4 prior to the application of the source and drain electrodes 2, 2a (in case of top gate OTFTs the insulating layer 3 and the plurality of gate electrodes 4 are applied after the patterning of the organic semiconductor layer - see Fig. 4).

As illustrated in Fig. 3, after the application of the continuous layer 9 of organic semiconducting material a solvent 8 is applied onto the continuous layer 9 of organic semiconducting material thereby dissolving and removing organic semiconducting material and forming a plurality of first regions 11 which comprise organic semiconducting material and a plurality of second regions 12 which do not comprise organic semiconducting material. By the use of the solvent 8 a patterned structure 10 of semiconducting material is formed. The solvent 8 is applied such that the channels 6 of each of the plurality of OTFTs is surrounded by a second region 12 or second regions 12. However, the first regions 11 are arranged such that they do not connect adjacent OTFTs. The plurality of OTFTs is arranged in a matrix on the substrate 5. The second regions 12 can be applied to form a line pattern or a pattern of annular regions 12 which surround the OTFTs. However it shall be understood that the continuous layer 9 is dissolved and removed by the solvent 8 such that none of the OTFTs is inter-connected to an adjacent OTFTs via the organic semiconducting material or via a first region 11. Therefore cross-talk between adjacent OTFTs can be avoided. The method is furthermore advantageous in comparison to direct patterning technologies (e.g. ink jet printing of organic semiconducting material) because the uniformity of the OTFTs is increased because the continuous layer 9 has high uniformity in respect of thickness, resistance etc. (ink jet printing causes a non uniform OSC layer profile due to the printing process, e.g. due to drying of the ink).

For the manufacture of a display according to the invention a plurality of OLEDs are applied onto the device as shown in Fig. 3. The OLEDs and the OTFTs (comprising source 2, drain 2a, channel 6, insulating layer 3 and gate 4) form pixels which are connected to driving circuits, such as a data driver and a scan driver (not shown). As known to a person skilled in the art one pixel of an active matrix display usually requires more that one OTFT. Therefore according to the invention a plurality of two or more OTFTs can be manufactured according to the present invention wherein each of the two or more OTFTs are arranged in a matrix pattern to the circuit for pixels of an organic electroluminescent device.

As shown in Fig. 4 two OTFTs are arranged adjacent to one another. Fig. 4 only shows a section of a plurality of TFTs wherein the adjacent pair of two OTFTs is not shown in Fig. 4. Independent of the arrangement of the OTFTs on the substrate (depending on the driving circuitry of the display) according to the invention the channel 6 of each OTFTs is formed from a continuous layer 9 of organic semiconducting material from which organic semiconducting material is dissolved and removed by use of a solvent 8 and each channel 6 is separated from an adjacent channel 6 or adjacent channels 6 by at least one second region 12 (comprising no organic semiconducting material).

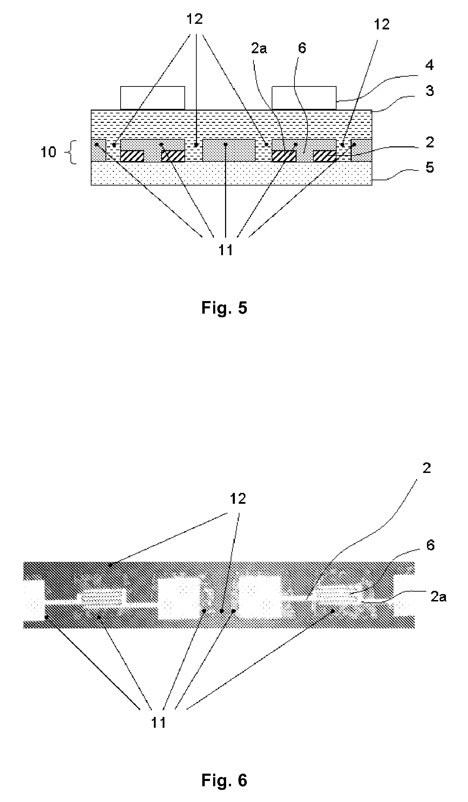

Fig. 5 and 6 show a cross sectional view and a top view of a section of a plurality of a top gate OTFTs comprising an OSC layer pattern 10 manufactured by printing a solvent 8 in order to dissolve a continuous OSC layer 9 around each OTFT.

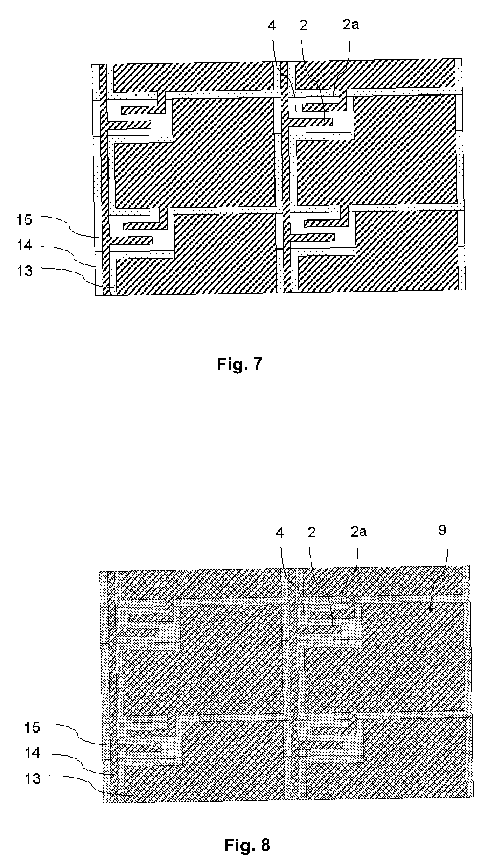

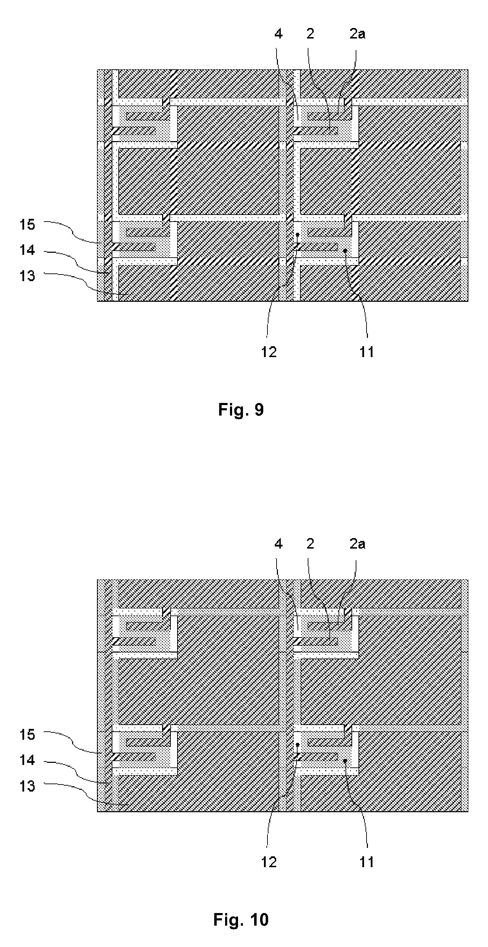

Fig. 7 to 10 show a top view of a section of a active matrix backplane comprising a plurality of a bottom gate OTFTs and pixel electrodes during different process steps. Fig. 7 shows a substrate with source and drain electrodes on top. The next process step is shown in Fig. 8. During this process the whole substrate area is covered by organic semiconductor. Fig. 9 and 10 show two ways to structure the OSC by the solvent printing method, i.e. by the application of a solvent for removing semiconducting material. Fig. 9 illustrates a simple line printing process and Fig. 10 demonstrates a OTFT by OTFT insulation printing.

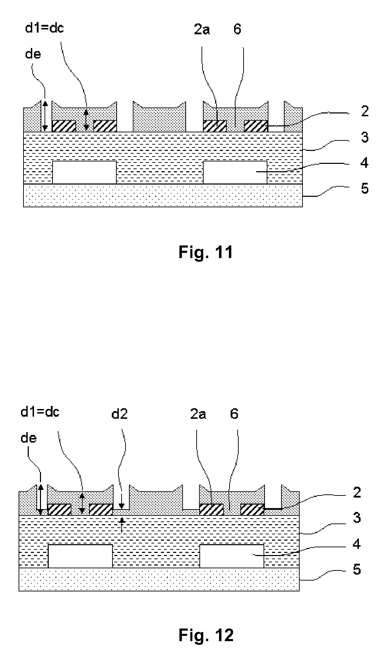

Fig. 11 and 12 show a realistic cross sectional view of two different possibilities of the OSC patterning. In both Figures the OSC material accumulation around the dissolved area is shown. Fig. 12 shows a sufficient reduction of OSC layer thickness to decrease the conductivity (thereby sufficiently avoiding cross-talk) and Fig. 11 illustrates the complete elimination of the OSC to minimize conductivity (and cross-talk).

While this invention has been described in conjunction with specific embodiments thereof, it is evident that many alternatives, modifications and variations will be apparent to those skilled in the art. Accordingly, the preferred embodiments of the invention as set forth herein are intended to be illustrative, not limiting. Various changes may be made without departing from the scope of the invention as defined in the following claims.

### List of Reference Signs

- 2: drain electrode
- 2a: source electrode
- 3: insulating material
- 4: gate electrode
- 5: substrate
- 6: channel
- 7: ink jet head
- 8: solvent
- 9: continuous layer of organic semiconducting material
- 10: patterned structure
- 11: first regions comprising organic semiconducting material
- 12: second regions not comprising organic semiconducting material
- 13: pixel electrode
- 14: data line
- 15: scan line

## Claims

1. A method of manufacturing a plurality of organic thin film transistors, comprising:
- providing a substrate (5),
- arranging a plurality of organic thin film transistors in a matrix on the substrate (5), each organic thin film transistor being formed of a source electrode (2a), a drain electrode (2), a channel (6) of semiconducting material, a gate insulating layer (3) and a gate electrode (4),
- wherein the plurality of channels (6) of the plurality of organic thin film transistors is formed by applying a continuous layer (9) of an organic semiconducting material over the plurality of source electrodes (2a) and drain electrodes (2),
**characterized in that**
a solvent (8) is applied such that the thickness of the organic semiconducting material is reduced in the continuous layer (9) in the area in which the solvent (8) is applied to sufficiently avoid-cross-talk, such that a plurality of first regions (11), which comprise organic semiconducting material, and a plurality of second regions (12), in which the organic semiconducting material is removed, are formed, and the minimum thickness of the organic semiconducting material in an area where no solvent (8) is applied is at least five times higher than the maximum thickness of the organic semiconducting material in the area in which the solvent (8) is applied.

2. The method according to claim 1,
wherein the semiconducting material is removed by evaporation.

3. The method according to claim 1 or 2,
wherein at least one of poly-3-alkylthiophene, poly-co-(dioctylfluorenyl-dithiophen-yl), poly-alkyltriarylamine, dihexylsexithiophene, starshaped oligothiophenes, poly(alkylterthiophene), poly(alkylquarterthiophene), functionalized acenes, functionalized pentacenes and bis-(tri-ethylsilylethinyl)-anthradithiophene) is used for the organic semiconducting material.

4. The method according to claim 3,
wherein at least one of Bis-(Tri-isopropylsilylethinyl)-Pentacene, Bis-(Tri-ethylsilylethinyl)-Pentacene, Bis-(Tri-methylsilylethinyl)-Pentacene, regioregular Poly-3-hexylthiophene and regioregular Poly-3-decylthiophene is used for the organic semiconducting material (1) and/or one of N-acetyl-6,13-epithioimino-6,13-dihydropentacene-S-oxide and 6,13-epitetrachlorbenzo-6,13-dihydropentacene is used as a pentacene pre-cursor.

5. The method according to one of the preceding claims,
wherein at least one of chloroform, tetrahydrofuran (THF), xylene, hexane, toluene, cyclohexane, anisole, 3,4dimethylanisole, 1,2dichlorobenzene, tetralin, 1,2,4trimethylbenzene, 1,2,3trimethlbenzene, 1,3,5trimethlbenzene, methyl benzoate, ethyl benzoate is used for the solvent (8).

6. The method according to one of the preceding claims,
wherein at least one second region (12) is formed between adjacent pairs of source and drain electrodes (2, 2a) wherein no second region (12) is formed between source electrodes (2a) and drain electrodes (2) of the same pair.

7. The method according to one of the preceding claims, wherein the second regions (12) form an annular pattern, which surround the organic thin film transistors.

8. The method according to one of claims 1 to 6, wherein the second regions (12) form a line pattern, which surround the organic thin film transistors, wherein the lines of the line pattern extend along a vertical and a horizontal axis of the matrix.

9. A semiconducting device comprising a plurality of organic thin film transistors in a matrix on the substrate (5) and a continuous layer (9) of an organic semiconductor material, each organic thin film transistor comprising a source electrode (2a), a drain electrode (2), a gate insulating layer (3) and a gate electrode (4), that are applied onto the substrate (5) prior to the continuous layer (9), and a channel (6) of semiconducting material, the organic semiconductor material having a patterned structure comprising a plurality of first and second regions (11, 12),
**characterized in that**
the semiconducting material of the semiconducting layer (9) is only partially removed in the second region (12) and the minimum thickness of the semiconducting layer (9) in the first region (11) is at least five times higher than the maximum thickness of the organic semiconducting material in the second region (12), wherein edges of the first regions (11) comprise a higher thickness (de) than a thickness (dc) of the central areas of the first regions (11).

10. The semiconducting element according to claim 9,
wherein a thickness (de) of an edge area of the first regions (11) is at least 10% higher than a thickness (dc) of a central area of the channel (6).

11. The semiconducting element according to one of the claim 10,
wherein the thickness (de) of the edge area of the first regions (11) is between 30 and 300% higher than the thickness (dc) of the central area of the channel (6).

12. The semiconducting element according to one of claims 9 to 11, wherein each channel (6) of the plurality of organic thin film transistors is surrounded by an annular pattern formed by the second region.

13. The semiconducting element according to one of claims 9 to 11, wherein each channel (6) of the plurality of organic thin film transistors is surrounded by a line pattern formed by the second region (12), wherein the lines of the line pattern extend along a vertical and a horizontal axis of the matrix.

## Patentansprüche

1. Methode zum Herstellen einer Vielzahl organischer Dünnschichttransistoren, umfassend:
- Bereitstellen eines Substrats (5),
- Anordnen einer Vielzahl organischer Dünnschichttransistoren in einer Matrix auf dem Substrat (5), wobei jeder organische Dünnschichttransistor aus einer Source-Elektrode (2a), einer Drain-Elektrode (2), einem Kanal (6) aus halbleitendem Material, einer Gate-Isolierschicht (3) und einer Gate-Elektrode (4) ausgebildet ist,
- wobei die Vielzahl von Kanälen (6) der Vielzahl organischer Dünnschichttransistoren durch Aufbringen einer kontinuierlichen Schicht (9) eines organischen halbleitenden Materials über der Vielzahl von Source-Elektroden (2a) und Drain-Elektroden (2) ausgebildet wird,
**dadurch gekennzeichnet, dass**
ein Lösungsmittel (8) so aufgebracht wird, dass die Stärke des organischen halbleitenden Materials in der kontinuierlichen Schicht (9) in dem Bereich, in dem das Lösungsmittel (8) aufgebracht wird, reduziert wird, um ein Übersprechen in ausreichendem Maß zu vermeiden, sodass eine Vielzahl erster Regionen (11), die organisches halbleitendes Material umfassen, und eine Vielzahl zweiter Regionen (12), in denen das organische halbleitende Material entfernt ist, ausgebildet werden, und die Mindeststärke des organischen halbleitenden Materials in einem Bereich, in dem kein Lösungsmittel (8) aufgebracht wird, zumindest fünfmal größer ist als die maximale Stärke des organischen halbleitenden Materials in dem Bereich, in dem das Lösungsmittel (8) aufgebracht wird.

2. Methode nach Anspruch 1,
wobei das halbleitende Material durch Verdampfung entfernt wird.

3. Methode nach Anspruch 1 oder 2,
wobei zumindest eines aus Poly-3-alkylthiophen, Poly-co-(dioctylfluorenyl-dithiophen-yl), Poly-alkyltriarylamin, Dihexylsexithiophen, sternförmigen Oligothiophenen, Poly(alkylterthiophen), Poly(alkylquarterthiophen), funktionalisierten Acenen, funktionalisierten Pentacenen und Bis-(tri-ethylsilylethinyl)-anthradithiophen) für das organische halbleitende Material verwendet wird.

4. Methode nach Anspruch 3,
wobei zumindest eines aus Bis-(Tri-isopropylsilylethinyl)-Pentacen, Bis-(Tri-ethylsilylethinyl)-Pentacen, Bis-(Tri-methylsilylethinyl)-Pentacen, regioregulärem Poly-3-hexylthiophen und regioregulärem Poly-3-decylthiophen für das organische halbleitende Material (1) verwendet wird und/oder eines aus N-acetyl-6,13-epithioimino-6,13-dihydropentacen-S-oxid und 6,13-Epitetrachlorbenzo-6,13-dihydropentacen als ein Pentacen-Präkursor verwendet wird.

5. Methode nach einem der vorangehenden Ansprüche,
wobei zumindest eines aus Chloroform, Tetrahydrofuran (THF), Xylen, Hexan, Toluen, Cyclohexan, Anisol, 3,4Dimethylanisol, 1,2Dichlorobenzen, Tetralin, 1,2,4Trimethylbenzen, 1,2,3Trimethlbenzen, 1,3,5Trimethlbenzen, Methylbenzoat, Ethylbenzoat für das Lösungsmittel (8) verwendet wird.

6. Methode nach einem der vorangehenden Ansprüche,
wobei zwischen benachbarten Paaren von Source- und Drain-Elektroden (2, 2a) zumindest eine zweite Region (12) ausgebildet ist, wobei zwischen Source-Elektroden (2a) und Drain-Elektroden (2) desselben Paars keine zweite Region (12) ausgebildet ist.

7. Methode nach einem der vorangehenden Ansprüche, wobei die zweiten Regionen (12) ein Ringmuster ausbilden, das die organischen Dünnschichttransistoren umgibt.

8. Methode nach einem der Ansprüche 1 bis 6, wobei die zweiten Regionen (12) ein Linienmuster ausbilden, das die organischen Dünnschichttransistoren umgibt, wobei sich die Linien des Linienmusters entlang einer vertikalen und einer horizontalen Achse der Matrix erstrecken.

9. Halbleitende Vorrichtung, umfassend eine Vielzahl organischer Dünnschichttransistoren in einer Matrix auf dem Substrat (5) und eine kontinuierliche Schicht (9) eines organischen halbleitenden Materials, wobei jeder organische Dünnschichttransistor eine Source-Elektrode (2a), eine Drain-Elektrode (2), eine Gate-Isolierschicht (3) und eine Gate-Elektrode (4), die vor der kontinuierlichen Schicht (9) auf das Substrat (5) aufgebracht werden, sowie einen Kanal (6) aus halbleitendem Material umfasst, wobei das organische halbleitende Material eine gemusterte Struktur aufweist, die eine Vielzahl erster und zweiter Regionen (11, 12) umfasst,
**dadurch gekennzeichnet, dass**
das halbleitende Material der halbleitenden Schicht (9) in der zweiten Region (12) nur teilweise entfernt ist und die Mindeststärke der halbleitenden Schicht (9) in der ersten Region (11) zumindest fünfmal größer als die maximale Stärke des organischen halbleitenden Materials in der zweiten Region (12) ist, wobei Kanten der ersten Regionen (11) eine größere Stärke (de) als eine Stärke (dc) der mittleren Bereiche der ersten Regionen (11) umfassen.

10. Halbleitendes Element nach Anspruch 9,
wobei eine Stärke (de) eines Kantenbereichs der ersten Regionen (11) zumindest 10 % größer als eine Stärke (dc) eines mittleren Bereichs des Kanals (6) ist.

11. Halbleitendes Element nach einem der Ansprüche 10,
wobei die Stärke (de) des Kantenbereichs der ersten Regionen (11) 30 bis 300 % größer als die Stärke (dc) des mittleren Bereichs des Kanals (6) ist.

12. Halbleitendes Element nach einem der Ansprüche 9 bis 11, wobei jeder Kanal (6) der Vielzahl organischer Dünnschichttransistoren von einem durch die zweite Region ausgebildeten Ringmuster umgeben ist.

13. Halbleitendes Element nach einem der Ansprüche 9 bis 11, wobei jeder Kanal (6) der Vielzahl organischer Dünnschichttransistoren von einem durch die zweite Region (12) ausgebildeten Linienmuster umgeben ist, wobei sich die Linien des Linienmusters entlang einer vertikalen und einer horizontalen Achse der Matrix erstrecken.,

## Revendications

1. Procédé de fabrication d'une pluralité de transistors organiques en film mince, comprenant les étapes consistant à :
- fournir un substrat (5),
- disposer une pluralité de transistors organiques en film mince dans une matrice sur le substrat (5), chaque transistor en film mince organique étant formé d'une électrode de source (2a), d'une électrode de drain (2), d'un canal (6) en matière semi-conductrice, d'une couche d'isolation de grille (3) et d'une électrode de grille (4),
- dans lequel la pluralité de canaux (6) de la pluralité de transistors organiques en film mince est formée par l'application d'une couche continue (9) d'une matière semi-conductrice organique au-dessus de la pluralité d'électrodes de source (2a) et d'électrodes de drain (2),
**caractérisé en ce que** :
un solvant (8) est appliqué de sorte que l'épaisseur de la matière semi-conductrice organique soit réduite dans la couche continue (9) dans la zone où le solvant (8) est appliqué pour éviter suffisamment les interférences, de sorte qu'une pluralité de premières régions (11), qui comprennent la matière semi-conductrice organique, et qu'une pluralité de secondes régions (12), dans lesquelles la matière semi-conductrice organique est retirée, soient formées, et l'épaisseur minimale de la matière semi-conductrice organique dans une zone où aucun solvant (8) n'est appliqué soit au moins cinq fois supérieure à l'épaisseur maximale de la matière semi-conductrice organique dans la zone où le solvant (8) est appliqué.

2. Procédé selon la revendication 1, dans lequel la matière semi-conductrice est retirée par évaporation.

3. Procédé selon la revendication 1 ou 2, dans lequel au moins un élément parmi le poly-3-alkylthiophène, le poly-co-(dioctylfluorényl-dithiophènyle), la poly-alkyltriarylamine, le dihexylsexithiophène, les oligothiophènes étoilés, le poly(alkylterthiophène), le poly(alkylquaterthiophène), les acènes fonctionnalisés, les pentacènes fonctionnalisés et le bis-(tri-éthylsilyléthinyl)-anthradithiophène est utilisé pour la matière semi-conductrice organique.

4. Procédé selon la revendication 3, dans lequel au moins un élément parmi le bis-(triisopropylsilyléthinyl)-pentacène, le bis-(triéthylsilyléthinyl)-pentacène, le bis-(triméthylsilyléthinyl)-pentacène, le poly-3-hexylthiophène régiorégulier et le poly-3-décylthiophène régiorégulier est utilisé comme matière semi-conductrice organique (1) et/ou un élément parmi le S-oxyde de N-acétyl-6,13-épithioimino-6,13-dihydropentacène et le 6,13-épitétrachlorobenzo-6,13-dihydropentacène est utilisé comme précurseur de pentacène.

5. Procédé selon l'une des revendications précédentes, dans lequel au moins un élément parmi le chloroforme, le tétrahydrofurane (THF), le xylène, l'hexane, le toluène, le cyclohexane, l'anisole, le 3,4-diméthylanisole, le 1,2-dichlorobenzène, la tétraline, le 1,2,4-triméthylbenzène, le 1,2,3-triméthylbenzène, le 1,3,5-triméthylbenzène, le benzoate de méthyle, le benzoate d'éthyle est utilisé comme solvant (8).

6. Procédé selon l'une des revendications précédentes, dans lequel au moins une seconde région (12) est formée entre des paires adjacentes d'électrodes de source et de drain (2, 2a), aucune seconde région (12) n'étant formée entre les électrodes de source (2a) et les électrodes de drain (2) de la même paire.

7. Procédé selon l'une des revendications précédentes, dans lequel les secondes régions (12) forment un motif annulaire, qui entoure les transistors organiques en film mince.

8. Procédé selon l'une des revendications 1 à 6, dans lequel les secondes régions (12) forment un motif linéaire, qui entoure les transistors organiques en film mince, les lignes du motif linéaire s'étendant le long d'un axe vertical et d'un axe horizontal de la matrice.

9. Dispositif semi-conducteur comprenant une pluralité de transistors organiques en film mince dans une matrice sur le substrat (5) et une couche continue (9) d'une matière semi-conductrice organique, chaque transistor organique en film mince comprenant une électrode de source (2a), une électrode de drain (2), une couche d'isolation de grille (3) et une électrode de grille (4), qui sont appliquées sur le substrat (5) avant la couche continue (9), et un canal (6) de matière semi-conductrice, la matière semi-conductrice organique ayant une structure en motifs comprenant une pluralité de premières et secondes régions (11, 12),
**caractérisé en ce que** :
la matière semi-conductrice de la couche semi-conductrice (9) est seulement partiellement retirée dans la seconde région (12) et l'épaisseur minimale de la couche semi-conductrice (9) dans la première région (11) est au moins cinq fois supérieure à l'épaisseur maximale de la matière semi-conductrice organique dans la seconde région (12), les bords des premières régions (11) comprenant une épaisseur (de) supérieure à une épaisseur (dc) des zones centrales des premières régions (11).

10. Elément semi-conducteur selon la revendication 9, dans lequel une épaisseur (de) d'une zone de bord des premières régions (11) est au moins 10 % supérieure à une épaisseur (dc) d'une zone centrale du canal (6).

11. Elément semi-conducteur selon la revendication 10, dans lequel l'épaisseur (de) de la zone de bord des premières régions (11) est entre 30 et 300 % supérieure à l'épaisseur (dc) de la zone centrale du canal (6).

12. Elément semi-conducteur selon l'une des revendications 9 à 11, dans lequel chaque canal (6) de la pluralité de transistors organiques en film mince est entouré d'un motif annulaire formé par la seconde région.

13. Elément semi-conducteur selon l'une des revendications 9 à 11, dans lequel chaque canal (6) de la pluralité de transistors organiques en film mince est entouré d'un motif linéaire formé par la seconde région (12), les lignes du motif linéaire s'étendant le long d'un axe vertical et d'un axe horizontal de la matrice.
